# EUROPÄISCHE PATENTSCHRIFT

(11) **EP 2 762 899 B1**
(45) Veröffentlichungstag und Bekanntmachung des Hinweises auf die Patenterteilung: **08.05.2019**
(21) Anmeldenummer: 13000566.3
(22) Anmeldetag: 04.02.2013
(51) Int. Cl.: G01R 11/04

(54) **Elektrizitätszähler mit ineinander eingerasteten Gehäuseteilen**
Electricity meter with interlocking housing parts
Compteur électrique avec éléments de boîtier enclenchés les uns dans les autres

(43) Veröffentlichungstag der Anmeldung: 06.08.2014
(73) Patentinhaber: EMH metering GmbH & Co. KG, 19258 Gallin (DE)
(72) Erfinder: Glomski, Marek, 21035 Hamburg (DE)
(74) Vertreter: Hauck Patentanwaltspartnerschaft mbB

(56) Entgegenhaltungen:
- EP-A2- 2 086 301
- EP-B1- 1 657 554
- DE-A1-102010 033 962
- DE-B1- 2 815 526
- DE-C1- 10 001 204
- DE-C1- 19 712 239
- DE-U1-202004 017 886
- JP-A- 2006 292 442
- US-A- 5 097 581
- US-A1- 2004 040 119
- US-A1- 2012 062 211

## Beschreibung

Die Erfindung betrifft einen Elektrizitätszähler mit einem unteren Gehäuseteil und einem oberen Gehäuseteil. Das untere Gehäuseteil weist erste Verriegelungselemente und das obere Gehäuseteil zweite Verriegelungselemente auf oder umgekehrt. Die ersten und zweiten Verriegelungselemente sind dazu ausgebildet, beim Zusammensetzen der beiden Gehäuseteile zu einem geschlossenen Gehäuse ineinander einzurasten.

Aus Sicherheitsgründen und zum Schutz vor Manipulationen müssen die Gehäuse von Elektrizitätszählern fest geschlossen sein. Hierzu ist es bekannt, die unterschiedlichen Gehäuseteile miteinander zu verschrauben. In diesem Fall muss ein unbefugtes öffnen des Gehäuses z.B. durch eine Plombierung der verwendeten Schrauben verhindert werden.

Sowohl vom Aufbau als auch von der Anwendung her ist es einfacher, die Gehäuseteile mit speziellen Verriegelungselementen zu versehen, die beim Zusammensetzen des Gehäuses ineinander einrasten. Eine solche Lösung ist aus der europäischen Patentschrift EP 1 657 554 B1 bekannt Der bekannte Elektrizitätszähler hat ein unteres, kastenförmiges Gehäuseteil, an dem im Bereich der Ecken vier Verriegelungsvorsprünge ausgebildet sind. Ein oberes Gehäuseteil wird von einer aufsetzbaren Haube gebildet, die vier Beine aufweist. An den Beinen sind Verriegelungsöffnungen ausgebildet. Beim Zusammensetzen der beiden Gehäuseteile rasten die Verriegelungsvorsprünge in die Verriegelungsöffnungen ein. Es ist dann nicht mehr möglich, die beiden Gehäuseteile zerstörungsfrei voneinander zu trennen. Die Vorteile dieser bekannten Konstruktion bestehen darin, dass die beiden Gehäuseteile einschließlich der Verriegelungselemente einfach gefertigt werden können, dass das Gehäuse sehr einfach geschlossen werden kann und zugleich wirksam vor unberechtigtem Zugriff schützt.

Aus der Druckschrift DE 10 2010 033 962 A1 ist ein Elektrizitätszähler mit den Merkmalen des Oberbegriffs des Anspruchs 1 bekannt geworden. Bei dem bekannten Elektrizitätszähler kann jede Entriegelungsöffnung mit einem einschnappenden Deckel verschlossen und vor unberechtigtem Zugriff geschützt werden.

Davon ausgehend ist es die Aufgabe der Erfindung, einen Elektrizitätszähler mit den eingangs genannten Merkmalen so zu verbessern, dass die genannten Vorteile erhalten bleiben, das Gehäuse jedoch bei Bedarf einfacher wieder geöffnet werden kann.

Diese Aufgabe wird gelöst durch den Elektrizitätszähler mit den Merkmalen des Anspruchs 1. Vorteilhafte Ausgestaltungen sind in den sich anschließenden Unteransprüchen angegeben.

Der Elektrizitätszähler hat ein unteres Gehäuseteil und ein oberes Gehäuseteil, wobei das untere Gehäuseteil erste Verriegelungselemente und das obere Gehäuseteil zweite Verriegelungselemente aufweist oder umgekehrt, wobei die ersten Verriegelungselemente und die zweiten Verriegelungselemente dazu ausgebildet sind, beim Zusammensetzen der beiden Gehäuseteile ineinander einzurasten, so dass sie sich anschließend im Inneren eines von den beiden Gehäuseteilen gebildeten, geschlossenen Gehäuses befinden, wobei das Gehäuse Entriegelungsöffnungen aufweist, durch die die ersten und/oder zweiten Verriegelungselemente bei geschlossenem Gehäuse von außen zugänglich sind, sodass sie in eine nicht ineinander eingerastete Stellung verlagert werden können, und eine Abdeckung vorhanden ist, die in einer Geschlossenstellung die Entriegelungsöffnungen abdeckt und vor unberechtigtem Zugriff schützt.

In dem Elektrizitätszähler können eine Leiterplatte, ein Mikroprozessor, Anschlussklemmen oder -kontakte zum Anschließen an ein Versorgungsnetz und an einen Verbraucher, eine optische Schnittstelle und/oder eine elektronische Anzeige angeordnet sein. Insbesondere die Leiterplatte, der Mikroprozessor, die optische Schnittstelle und/oder die elektronische Anzeige können innerhalb des von dem unteren Gehäuseteil und dem oberen Gehäuseteil gebildeten Gehäuses angeordnet sein. Das untere Gehäuseteil kann eine Grundplatte aufweisen. Die Anschlussklem-men oder -kontakte sind an dem unteren Gehäuseteil befestigt. Die Leiterplatte kann an dem unteren Gehäuseteil befestigt sein. Das obere Gehäuseteil bildet eine Frontseite des Elektrizitätszählers oder Teile davon. Es kann einen umlaufenden, rahmenartigen Abschnitt aufweisen. Das untere Gehäuseteil kann etwa kastenförmig ausgebildet sein mit einem umlaufenden, rechteckigen Rahmen.

Das obere Gehäuseteil und das untere Gehäuseteil können an einer Trennungsebene aneinander angrenzen und dort derart ineinandergreifen, dass eine Relativbewegung zwischen den beiden Gehäuseteilen in der Trennungsebene bei geschlossenem Gehäuse ausgeschlossen ist.

Das untere Gehäuseteil und das obere Gehäuseteil können aus Kunststoff gefertigt sein, insbesondere in einem Spritzgießverfahren. Das untere Gehäuseteil mit den zugehörigen Verriegelungselementen kann einteilig gefertigt sein. Das obere Gehäuseteil mit den zugehörigen Verriegelungselementen kann einteilig gefertigt sein. Das untere Gehäuseteil und das obere Gehäuseteil können jeweils mindestens zwei, bevorzugt vier Verriegelungselemente aufweisen. Die Verriegelungselemente können an den Ecken des betreffenden Gehäuseteils angeordnet sein. Beim Zusammensetzen der beiden Gehäuseteile zum geschlossenen Gehäuse rasten die Verriegelungselemente ineinander ein. Dadurch wird verhindert, dass die Gehäuseteile in der dem Zusammensetzen entgegengesetzten Richtung wieder voneinander entfernt werden können.

Bei der Erfindung weist das Gehäuse Entriegelungsöffnungen auf. Diese sind im oberen Gehäuseteil ausgebildet. Jedem an dem oberen Gehäuseteil angeordneten Verriegelungselement kann eine Entriegelungsöffnung zugeordnet sein. Durch die Verriegelungsöffnungen hindurch sind die ersten und/oder zweiten Verriegelungselemente bei geschlossenem Gehäuse von außen
zugänglich. Durch diese Zugangsmöglichkeit können die Verriegelungselemente bei geschlossenem Gehäuse in eine nicht ineinander eingerastete Stellung verlagert werden, ggfs. unter Zuhilfenahme eines Entriegelungswerkzeugs. Befinden sich alle Verriegelungselemente in der nicht ineinander eingerasteten Stellung, können das obere Gehäuseteil und das untere Gehäuseteil wieder voneinander entfernt werden.

Bei der Erfindung sind die Entriegelungsöffnungen vor unberechtigtem Zugriff durch eine Abdeckung geschützt, die die Entriegelungsöffnungen in einer Geschlossenstellung abdeckt. Bei geschlossener Abdeckung kann das Gehäuse daher trotz der Entriegelungsöffnungen nicht geöffnet werden.

Die Abdeckung ist ein weiteres Gehäuseelement des Elektrizitätszählers, das zusätzlich zur Abdeckung der Entriegelungsöffnungen weitere Funktionen erfüllt. Die Abdeckung weist ein Sichtfenster auf, hinter dem ein Schild, eine elektronische Anzeige und/oder eine optische Schnittstelle des Elektrizitätszählers angeordnet ist. Die Abdeckung kann eine Frontseite des Elektrizitätszählers oder einen Teil davon bilden. Alternativ oder zusätzlich kann die Abdeckung elektrische Anschlüsse des Elektrizitätszählers abdecken.

In einer Ausgestaltung ist die Abdeckung dazu ausgebildet, mittels einer Plombe in der Geschlossenstellung gesichert zu werden. Hierzu kann die Abdeckung eine Öffnung aufweisen, durch die eine Plombierschraube, eine Stiftplombe oder ein Plombierdraht hindurchgeführt wird. Die Abdeckung kann beispielsweise eine Klappe sein, die nach Entfernen der Plombe aufgeklappt werden kann. Dass die Abdeckung in der Geschlossenstellung gesichert wird, bedeutet, dass sie nicht ohne Entfernung bzw. Beschädigung der Plombe aus der Geschlossenstellung entfernt werden kann, sodass ein unberechtigter Zugriff nicht unbemerkt bleibt.

In einer Ausgestaltung ist die Abdeckung so ausgebildet, dass sie nicht zerstörungsfrei aus der Geschlossenstellung entfernt werden kann. In diesem Fall ist eine zusätzliche Sicherung der Abdeckung mittels einer Plombe nicht erforderlich, weil die Abdeckung oder ein damit zusammenwirkendes Gehäuseteil beim Entfernen aus der Geschlossenstellung zerstört oder beschädigt wird, sodass auch ein solches Öffnen der Abdeckung nachträglich festgestellt werden kann.

In einer Ausgestaltung weist die Abdeckung Verriegelungsabschnitte auf, die in der Geschlossenstellung in die Entriegelungsöffnungen eingreifen und diese verschließen. Mit den Verriegelungsabschnitten wird die Abdeckung an dem Gehäuseteil, das die Entriegelungsötmung aufweist, befestigt. Dadurch, dass die Verriegelungsabschnitte in die Entriegelungsöffnungen eingreifen, wird die Zugangsmöglichkeit durch diese Entriegelungsöffnungen hindurch besonders wirksam blockiert. Die Verriegelungsabschnitte der Abdeckung verschließen die Entriegelungsöffnungen. Ein weiterer Vorteil besteht darin, dass die Entriegelungsöffnungen gleichzeitig als Aufnahmen für die Verriegelungsabschnitte verwendet werden, sodass insgesamt ein besonders kompakter Aufbau ermöglicht wird.

In einer Ausgestaltung weisen die Verriegelungsabschnitte der Abdeckung Verriegelungsausnehmungen oder Verriegelungsöffnungen auf und das obere Gehäuseteil Abdeckungsverriegelungsvorsprünge, die in der Geschlossenstellung in die Verriegelungsausnehmungen oder Verriegelungsöffnungen eingreifen. Die Abdeckungsverriegelungsvorsprünge können jeweils benachbart zu einer Entriegelungsöffnung angeordnet sein. Sie können unbeweglich am oberen Gehäuseteil angeordnet sein und mit elastisch verlagerbaren Verriegelungsabschnitten der Abdeckung zusammenwirken. Alternativ können die Verriegelungsabschnitte der Abdeckung relativ starr ausgebildet sein und die Abdeckungsverriegelungsvorsprünge gegenüber dem oberen Gehäuseteil elastisch verlagerbar sein, beispielsweise an federnden Beinen angeordnet, um in die Verriegelungsausnehmung der Verriegelungsöffnungen einrasten zu können.

In einer Ausgestaltung sind die Entriegeluogsöffnungen bei geschlossenem Gehäuse relativ zu den ersten und zweiten Verriegelungselementen so angeordnet, dass ein stiftförmiges Entriegelungswerkzeug durch eine Entriegelungsöffnung hindurch zwischen ein erstes Verriegelungselement und ein zweites Verriegelungselement geschoben werden kann. Durch das Einschieben eines solchen Entriegelungswerkzeugs zwischen zwei zusammenwirkende Verriegelungselemente ist die angestrebte Verlagerung der Verriegelungsclementc in eine nicht ineinander eingerastete Stellung besonders einfach möglich. Insbesondere ist es hierfür nicht erforderlich, das Entriegelungswerkzeug an einem von den Verriegelungselementen entfernten Gehäusebereich abzustützen und die Verrastung durch einen hebelartigen Einsatz des Werkzeugs "aufzuhebeln". Die für die Verlagerung des oder der Verriegelungselemente aufzubringende Kraft wird stattdessen mit Hilfe des Werkzeugs direkt zwischen den beiden Verriegelungselementen ausgeübt, was das Aufheben der Verriegelung insbesondere bei einem größeren Abstand zwischen Entriegelungsöffnung und den Verriegelungselementen spürbar vereinfacht.

In einer Ausgestaltung sind am oberen Gehäuseteil und/oder am unteren Gehäuseteil Führungsflächen ausgebildet, entlang denen das Entriegelungswerkzeug zwischen ein erstes und ein zweites Verriegelungselement geschoben werden kann. Dadurch kann das Entriegelungswerkzeug einfach an den Führungsflächen entlang in die richtige Position vorgeschoben werden.

In einer Ausgestaltung sind die Abdeckungsverriegelungsvorsprünge rippenförmige Rastnasen und die Führungsflächen sind seitliche Flächen dieser Rastnasen. In diesem Fall dienen also die für die Verriegelung der Abdeckung vorgesehenen Vorsprünge gleichzeitig als Führungsflächen, was den Aufbau des Elektrizitätszählers nochmals vereinfacht und eine besonders platzsparende Anordnung aller für die Verriegelung und Entriegelung erforderlichen Elemente ermöglicht.

In einer Ausgestaltung weisen die ersten Verriegelungselemente jeweils eine Verriegelungsöffnung und die zweiten Verriegelungselemente jeweils zwei benachbart angeordnete Verriegelungsvorsprünge auf, die dazu ausgebildet sind, beide in dieselbe Verriegelungsöffnung einzugreifen, wobei zwischen den beiden Verriegelungsvorsprüngen ein Freiraum ausgebildet ist, durch den das Entriegelungswerkzeug vorgeschoben werden kann. Durch diese Ausformung der Verriegelungselemente wird der vorgesehene Einsatz des Entriegelungswerkzeugs nochmals vereinfacht. Insbesondere wird sichergestellt, dass das Entricgelungswerkzeug bei der Verlagerung der Verriegelungselemente in die nicht ineinander eingerastete Stellung vom zweiten Verriegelungselement abrutscht. Außerdem begünstigt die symmetrische Ausbildung der zweiten Verriegelungselemente eine Auslenkung dieser Verriegelungselemente in die gewünschte Richtung.

In einer Ausgestaltung weisen die ersten Verriegelungselemente jeweils eine Schrägfläche auf, die so angeordnet ist, dass das durch eine Entriegelungsöffnung eingeschobene, gegen die Schrägfläche gepresste Entriegelungswerkzeug das betreffende erste Verriegelungselement von dem zugehörigen zweiten Verriegelungselement entfernt. Durch die Schrägfläche wird die vom Entriegelungswerkzeug ausgeübte Kraft, die dieses beim Vorschieben auf das erste Verriegelungselement ausübt, in die gewünschte Richtung umgelenkt. Außerdem kann die Schrägfläche eine Führungswirkung auf die Spitze des Entriegelungswerkzeugs ausüben.

In einer Ausgestaltung sind die Schrägflächen jeweils an einer der Verriegelungsöffnungen zwischen zwei Anschlagflächen angeordnet hinter denen bei geschlossenem Gehäuse jeweils einer der Verriegehmgsvorsprünge eingerastet ist. Bei dieser Anordnung der Schrägflächen wirkt die Kraft auf die ersten Verriegelungselemente exakt dort, wo der Eingriff mit den korrespondierenden Verriegelungsvorsprüngen aufgehoben werden soll.

In einer Ausgestaltung sind am unteren Gehäuseteil Verriegelungsflächen ausgebildet, die bei geschlossenem Gehäuse jeweils eine Auslenkung eines freien Endes eines der ersten Verriegelungselemente verhindern. Die Verriegelungsflächen können Abschnitte aufweisen, die schräg zu einer Richtung angeordnet sind, entlang der das obere und das untere Gehäuseteil zusammengesetzt werden. Dadurch können sie die freien Enden der ersten Verriegelungselemente bereits beim Zusammensetzen des Gehäuses in eine Richtung pressen, in der die ersten Verriegelungselemente und die zugehörigen zweiten Verriegelungselemente ineinander einrasten. In Verbindung mit der vorgesehenen Öffnungsmöglichkeit wird durch die Fixierung der freien Enden der ersten Verriegelungselemente bei geschlossenem Gehäuse die Öffnung des Gehäuses gezielt erschwert, sodass sie nur mit einem geeigneten Spezialwerkzeug einfach gelingt. Die freien Enden der ersten Verriegelungselemente können einen Abstand von den Verriegelungsöffnungen dieser Verriegelungselemente aufweisen, beispielsweise einen Abstand von 1 cm oder mehr.

In einer Ausgestaltung ist der Elektrizitätszähler mit einem Entriegelungswerkzeug kombiniert, das zwei über einen Griffabschnitt miteinander verbundene, parallel verlaufende Stifte aufweist. Der Abstand dieser Stifte voneinander entspricht dem Abstand zweier Entriegelungsöffnungen des Gehäuses, sodass die beiden Stifte gleichzeitig in das Gehäuse eingeführt werden können. Zum Öffnen eines Gehäuses mit vier Entriegelungsöffnungen können bevorzugt zwei derartige Entriegelungswerkzeuge gleichzeitig eingesetzt werden. Dadurch wird das Öffnen erheblich vereinfacht, weil jedes der beiden Werkzeuge mit einer Hand geführt werden kann und bei Verwendung von vier ersten und vier zweiten Verriegelungselementen alle vier Verriegelungen gleichzeitig aufgehoben werden können. Die Stifte können aus Stahl bestehen, einen kreisrunden oder eckigen Querschnitt aufweisen und Querschnittsabmessungen im Bereich von etwa 2 mm bis 6 mm.

In einer Ausgestaltung weisen die Stifte jeweils einen geradlinigen Abschnitt auf, der mit dem Griffabschnitt verbunden ist, und einen vorderen Abschnitt, der gegenüber dem geradlinigen Abschnitt abgewinkelt ist. Insbesondere kann der vordere Abschnitt in einem Winkel im Bereich von 2° bis 30° abgewinkelt sein. In Verbindung mit entsprechend geformten ersten und/oder zweiten Verriegelungselementen kann der vordere Abschnitt in diesem Fall besonders einfach zwischen die betreffenden Verriegelungselemente geschoben werden.

Nachfolgend wird die Erfindung anhand eines in Figuren dargestellten Ausführungsbeispiels näher erläutert. Es zeigen:
- Fig. 1: einen erfindungsgemäßen Elektrizitätszähler in einer perspektivischen Darstellung,
- Fig. 2: das obere Gehäuseteil mit Abdeckung des Elektrizitätszählers aus Fig. 1 in einer perspektivischen Darstellung,
- Fig. 3: die Abdeckung des Elektrizitätszählers aus Fig. 1 in einer perspektivischen Darstellung,
- Fig. 4: die Anordnung aus Fig. 2 in einer ersten geschnittenen Darstellung,
- Fig. 5: die Anordnung aus Fig. 2 in einer zweiten geschnittenen Darstellung,
- Fig. 6: ein erstes Verriegelungselement des oberen Gehäuseteils des Elektrizitätszählers aus Fig. 1 in einer vergrößerten Darstellung,
- Fig. 7: unteres Gehäuseteil und oberes Gehäuseteil des Elektrizitätszählers aus Fig. 1 in einer perspektivischen Darstellung,
- Fig. 8: unteres Gehäuseteil und oberes Gehäuseteil mit Abdeckung des Elektrizitätszählers aus Fig. 1 in einer geschnittenen Ansicht,
- Fig. 9: zwei Entriegelungswerkzeuge für den Elektrizitätszähler aus Fig. 1 in einer perspektivischen Darstellung,
- Fig. 10: die Anordnung aus Fig. 7 mit eingeschobenen Entriegelungswerkzeugen in einer perspektivischen Darstellung,
- Fig. 11: die Anordnung aus Fig. 10 in einer ersten geschnittenen Darstellung,
- Fig. 12: die Anordnung aus Fig. 10 in einer zweiten geschnittenen Darstellung,
- Fig. 13: die Anordnung aus Fig. 10 in einer weiteren geschnittenen Ansicht.

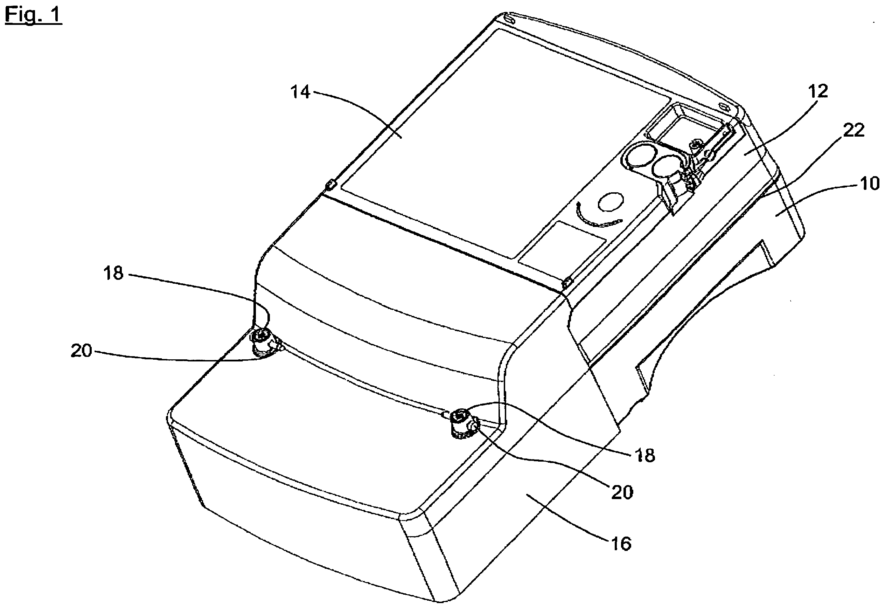

Der Elektrizitätszähler aus Fig. 1 weist ein unteres Gehäuseteil 10, ein oberes Gehäuseteil 12, eine Abdeckung 14 und einen Klemmendeckel 16 auf. Das untere Gehäuseteil 10 ist etwa kastenförmig und weist eine in der Fig. 1 nicht sichtbare Grundplatte auf sowie einen umlaufenden, rahmenförmigen Abschnitt auf. Das obere Gehäuseteil 12 ist oberhalb des unteren Gehäuseteil 10 angeordnet und grenzt in einer Trennungsebene 22 an das untere Gehäuseteil 10 an. Fig. 1 zeigt das Gehäuse nach dem Zusammensetzen des unteren Gehäuseteil 10 mit dem oberen Gehäuseteil 12, also als geschlossenes Gehäuse, bei dem die an den Gehäuseteilen 10, 12 ausgebildeten ersten und zweiten Verriegelungselemente ineinander eingerastet sind.

Die Abdeckung 14 ist oberhalb des oberen Gehäuseteils 12 angeordnet und besteht im gezeigten Ausführungsbeispiel vollständig aus einem transparenten Kunststoffmaterial. In der Abdeckung 14 sind mehrere Sichtfenster ausgebildet.

Der Klemmendeckel 16 ist mit zwei Plombierschrauben 18, die jeweils mit einer Stiftplombe 20 gesichert sind, gegen unbefugten Zugriff geschützt an den übrigen Gehäuseteilen angeordnet.

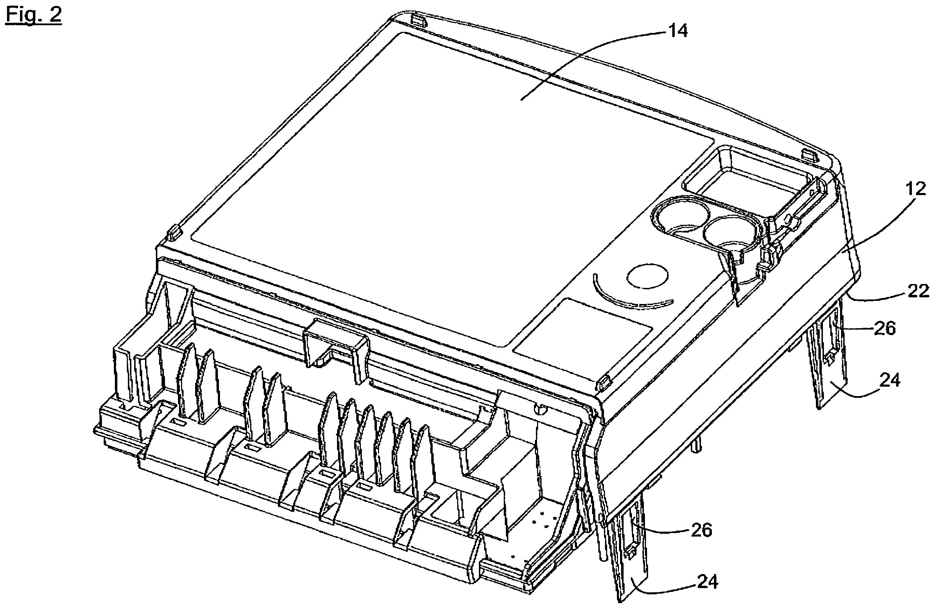

In der Figur 2 sind zur besseren Darstellung der Klemmendeckel 16 und das untere Gehäuseteil 10 entfernt. Die Abdeckung 14 ist weiterhin mit dem oberen Gehäuseteil 12 verbunden dargestellt. Am oberen Gehäuseteil 12 sind insgesamt vier erste Verriegelungselemente 24 ausgebildet, die einteilig mit dem oberen Gehäuseteil 12 gefertigt sind. Sie befinden sich etwa an den vier Ecken des oberen Gehäuseteils 12 und erstrecken sich von zwei gegenüberliegenden, scitlichen Wandungen des oberen Gehäuseteils 12 ausgehend nach unten über die Trennungsebene 22 hinaus.

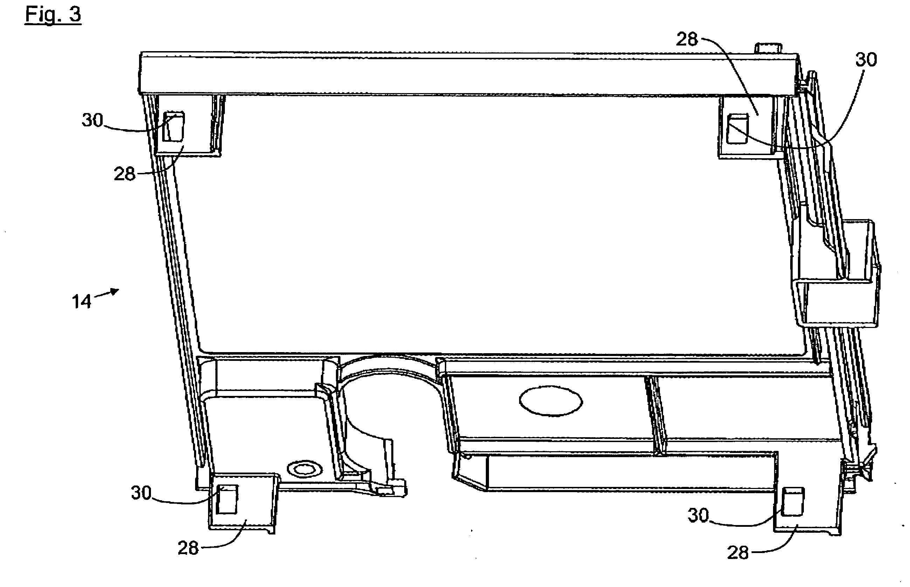

Figur 3 zeigt die Abdeckung 14 in einer perspektivischen Ansicht schräg von unten. Man erkennt vier an den Ecken der Abdeckung 14 angeordnete Verriegelungsabschnitte 28, die jeweils eine Verriegelungsöffnung 30 aufweisen.

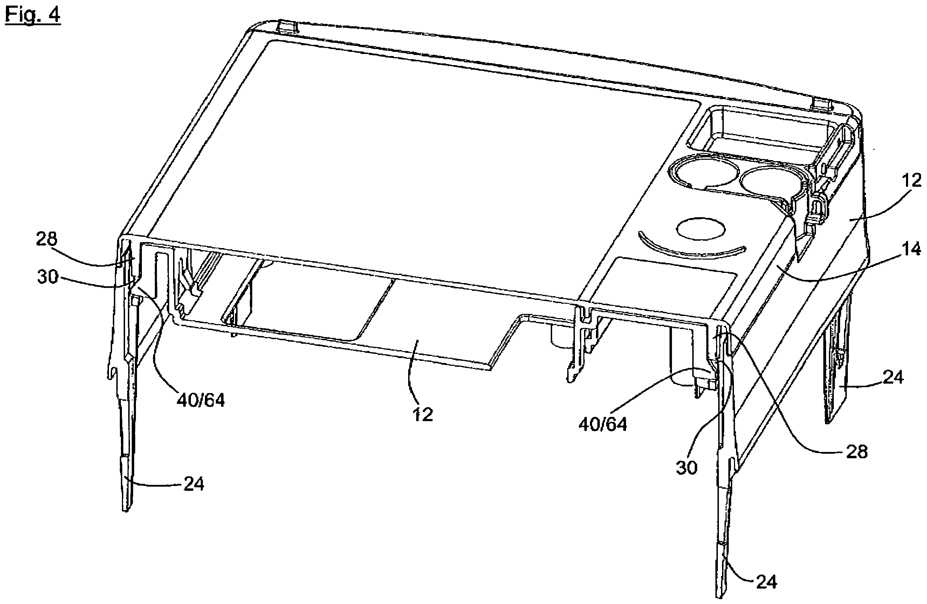

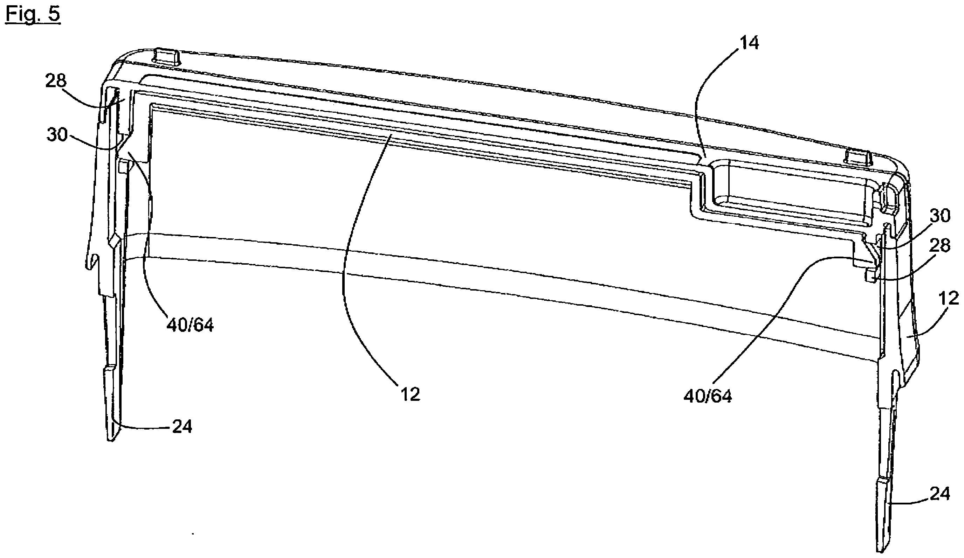

Die Fign. 4 und 5 zeigen jeweils die Anordnung der Fig. 2 in geschnittenen Darstellungen mit unterschiedlicher Schnittebene. In der Fig. 4 verläuft die Schnittebene durch die beiden in Fig. 2 weiter vorn angeordneten ersten Verriegelungselemente 24 und Verriegelungsabschnitte 28, in der Fig. 5 durch die beiden in Fig. 2 weiter hinten angeordneten ersten Verriegelungselemente 24 und Vcrriegelungsabschnitte 28. In Fig. 4 und Fig. 5 erkennt man jeweils zwei an dem oberen Gehäuseteil angeordnete Abdeckungsverriegelungsvorsprünge 40. Diese sind rastnasenförmig und greifen jeweils in eine Verriegelungsöffnung 30 eines Verriegelungsvorsprungs 28 der Abdeckung 14 ein.

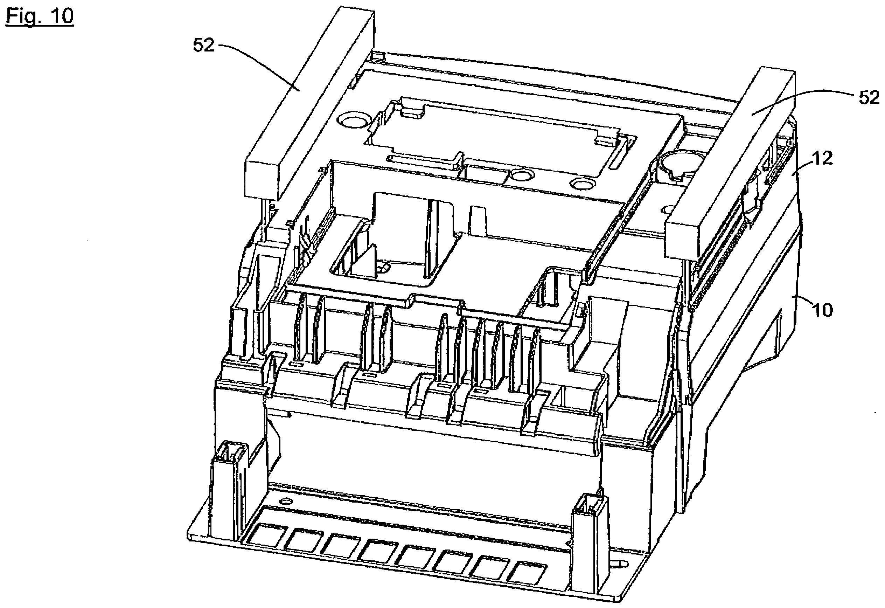

Die in den Fign. 4 und 5 dem Betrachter zugewandten seitlichen Flächen der Abdeckungsverriegelungsvorsprünge bilden Führungsflächen 64, entlang denen ein Entriegelungswerkzeug vorgeschoben werden kann (siebe hierzu z.B. Fig. 10).

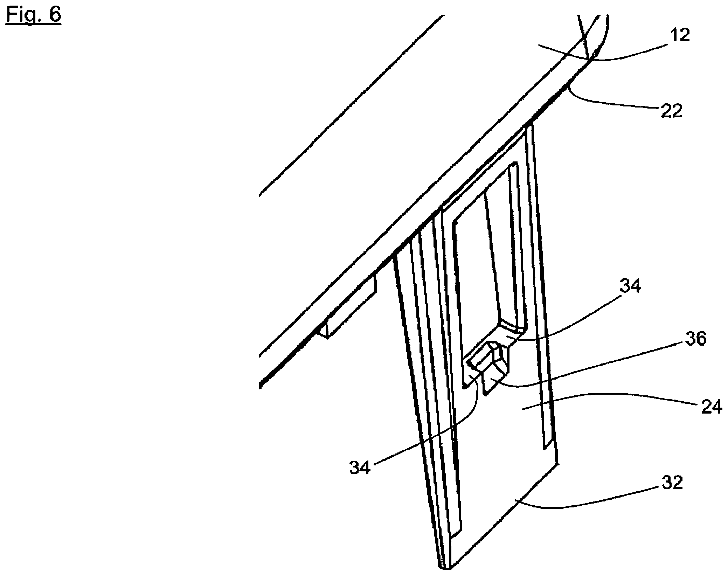

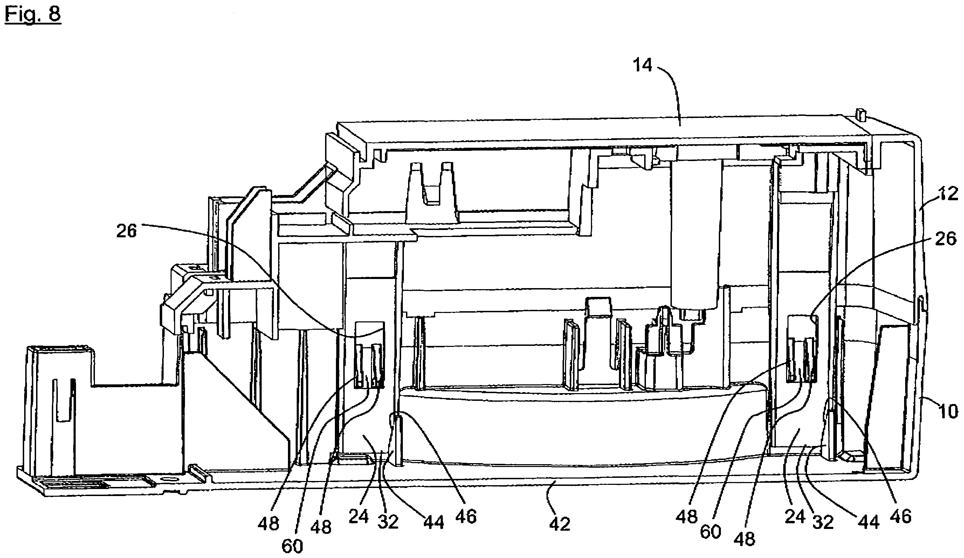

Fig. 6 zeigt eines der ersten Verriegelungselemente 24 in einer vergrößerten Darstellung. Man erkennt die streifenförmige Grundform des ersten Verriegelungselements 24 und dass die Materialstärke des ersten Verriegelungselementes 24 mit zunchmendem Abstand von der Trennungsebene 22 abnimmt, das erste Verriegelungselement 24 also nach unten relativ schmal zu einem freien Ende 32 des ersten Verriegelungselementes 24 hin ausläuft. Die Verriegelungsöffnung 26 ist rechteckig. Ein oberes Ende der Verriegelungsöffnung 26 ist nahe an der Trennungsebene 22 angeordnet Das untere Ende der Verriegelungsöffnung 26 befindet sich in einem größeren Abstand von der Trennungsebene 22 und außerdem in einem Abstand von mindestens 1 cm von dem freien Ende 32 des ersten Verriegelungselementes 24. Die die rechteckige Verriegelungsöffnung 26 nach unten hin begrenzende Fläche weist zwei seitlich angeordnete Anschlagflächen 34 auf, hinter denen jeweils ein in der Fig. 6 nicht gezeigter Verriegelungsvorsprung 48 (siehe z.B. Fig. 8) eines zweiten Verriegelungsabschnitts des unteren Gehäuseteils 10 einrastet. Zwischen den beiden Anschlagflächen 34 ist außerdem eine Schrägfläche 36 angeordnet. Diese fällt nach außen und unten hin ab, d.h. mit zunehmendem Abstand von einer Mitte des oberen Gehäuseteils 12 in Richtung zu dem freien Ende 32 hin.

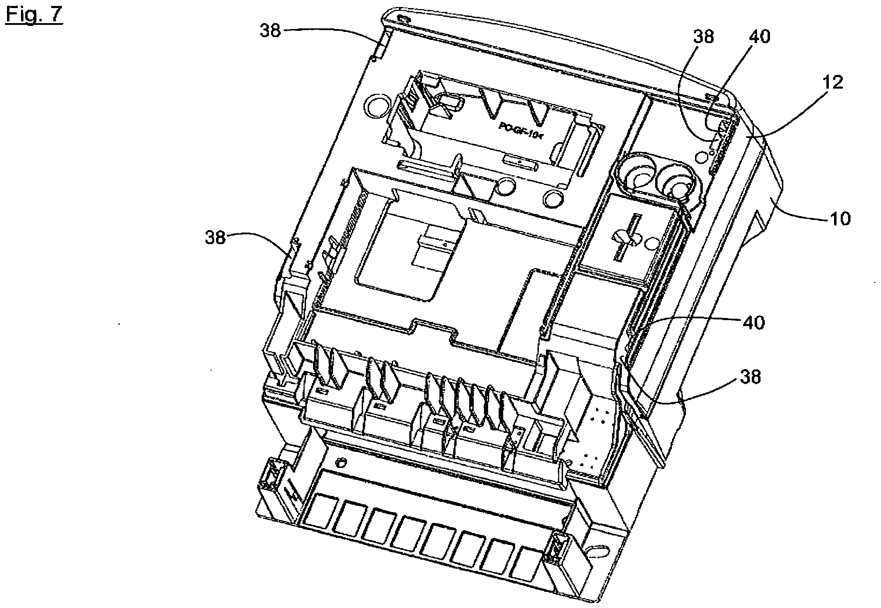

In der Fig. 7 ist die Abdeckung 14 entfernt, sodass etwa an den vier Ecken des oberen Gehäuseteils 12 jeweils eine Entriegelungsöffnung 38 sichtbar ist Die Entriegelungsöffnungen 38 weisen jeweils einen etwa rechteckigen Querschnitt auf und befinden sich an Positionen, die der Anordnung der Verriegelungsabschnitte 28 der Abdeckung 14 entsprechen. Um die Abdeckung 14 in ihre Geschlossenstellung zu bringen (wie z.B. in Fig. 1 gezeigt), werden die Verriegelungsabschnitte 28 in die Entriegelungsöffnungen 38 eingesetzt, bis die Abdeckungsverriegelungsvorsprünge 40 in die Verriegelungsöffnungen 30 der Verriegelungsabschnitte 28 einrasten. Anschließend kann die Abdeckung 14 nicht mehr von dem oberen Gehäuseteil 12 entfernt werden, ohne die Abdeckungsverriegelungsvorsprünge 40 oder die Verriegelungsabschnitte 28 zu beschädigen.

Fig. 8 bietet eine Ansicht aus dem Inneren des Elektrizitätszählers, gerichtet auf dessen linke Seitenwand. Das untere Gehäuseteil 10 und das obere Gehäuseteil 12 befinden sich in ihrer zusammengesetzten Stellung. Die Abdeckung 14 befindet sich in ihrer Geschlossenstellung, also in die Entriegelungsöffnungen 38 des oberen Gehäuseteils 12 eingerastet. Gut erkennbar sind die ersten Verriegelungselemente 24, deren freie Enden 32 bis nahe an eine Grundplatte 42 des unteren Gehäuseteils 10 heranreichen. Unmittelbar benachbart zu den freien Enden 32 der ersten Verriegelungselemente 24 sind an der Grundplatte 42 Stege 44 ausgebildet, die jeweils eine schräggestellte Verriegelungsfläche 46 aufweisen. Diese Verriegelungsflächen 46 verhindern, dass die freien Enden 32 der ersten Verriegelungselemente 24 in das Innere des Gehäuses hinein verlagert werden können.

Ebenfalls gut in der Figur 8 erkennbar sind die am unteren Gehäuseteil 10 ausgebildeten zweiten Verriegelungselemente. Diese weisen jeweils zwei rastnasenförmigen Verriegelungsvorsprüngen 48 auf, die an der Innenseite eines rahmenförmig umlaufenden Abschnitts des unteren Gehäuseteils 10 nach innen weisend ausgebildet sind. Zwischen jedem Paar dieser Verriegelungsvorsprünge 48 ist ein Freiraum 60 ausgebildet. Zu den zweiten Verriegelungselementen zählen außerdem die die beiden Verriegelungsvorsprünge 48 miteinander verbindenden Abschnitte des unteren Gehäuseteils 10.

Jeweils zwei der benachbart angeordneten Verriegelungsvorsprünge 48 sind in eine Verriegelungsöffnung 26 eines ersten Verriegelungselements 24 eingerastet. Daher können unteres Gehäuseteil 10 und oberes Gehäuseteil 12 nicht ohne Weiteres voneinander entfernt werden.

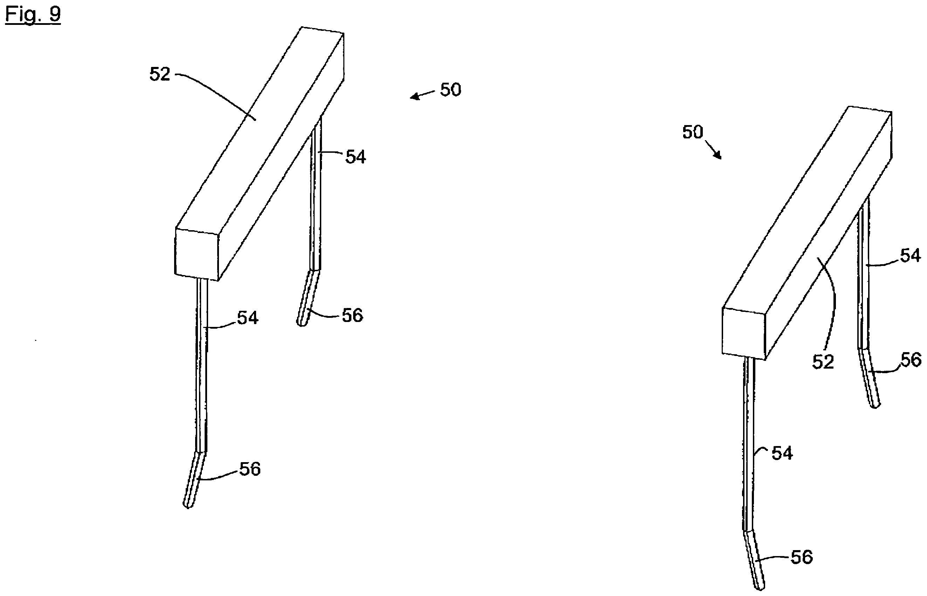

Fig. 9 zeigt zwei Entriegelungswerkzeuge 50, die jeweils einen Griffabschnitt 52 und zwei daran befestigte, parallel zueinander verlaufende Stifte 54 aufweisen. Jeder Stift 54 hat einen vorderen Abschnitt 56, der gegenüber dem mit dem Griffabschnitt 52 verbundenen, hinteren Abschnitt des Stifts 54 leicht abgewinkelt ist. Der Abstand zwischen den beiden Stiften 54 eines Entriegelungswerkzeugs 50 entspricht genau dem Abstand zwischen zwei Entriegelungsöffnungen 38 im oberen Gehäuseteil 12.

Darum lassen sich die Entriegelungswerkzeuge 50 nach dem Entfernen der Abdeckung 14 durch die Entriegelungsöffnungen 38 hindurch einfach in die geschlossene Anordnung von unterem Gehäuseteil 10 und oberem Gehäuseteil 12 einschieben. Dies ist in der Fig. 10 gezeigt.

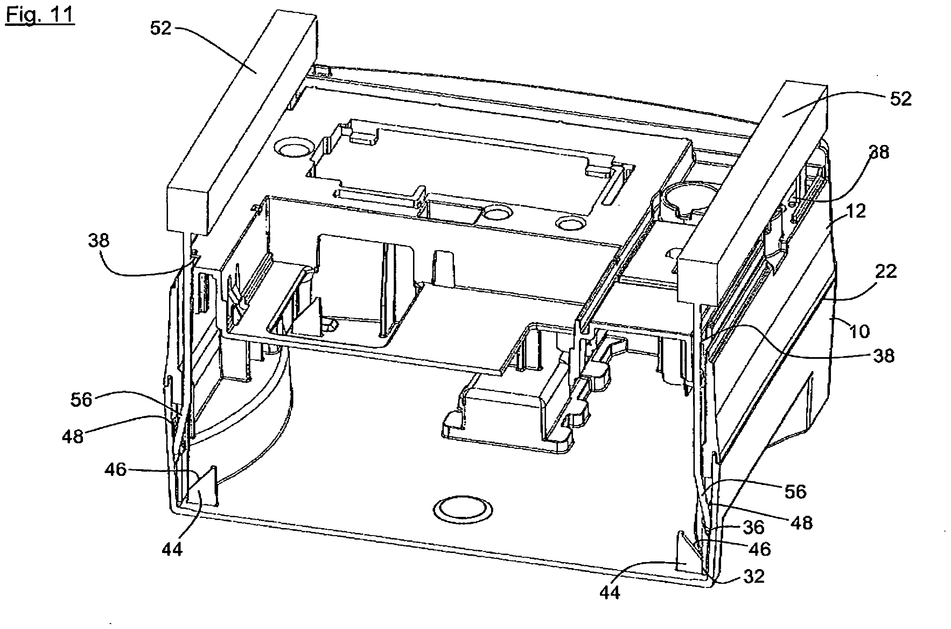

In der Fig. 11 sind dieselben Elemente wie in der Fig. 10 dargestellt, wobei die Schnittebene durch die beiden vorderen Stifte 54 der beiden Entriegelungswerkzeuge 50 hindurch verläuft. Man erkennt in dieser Darstellung, dass jeder der Stifte 54 in eine Entriegelungsöffnung 38 hineingeführt ist. In der Schnittebene ist außerdem erkennbar, dass die abgewinkelten, vorderen Abschnitte 56 der Stifte 54 gerade in jeweils einen Freiraum 60 zwischen zwei Verriegelungsvorsprüngen 48 eingreifen. Die in der Figur sichtbaren Verriegelungsvorsprünge 48 sind jeweils hinter einer Anschlagfläche 34 in einer Verriegelungsöffnung 26 eines ersten Verriegelungselements 24 eingerastet

Werden die Entriegelungswerkzeuge 50 noch etwas weiter vorgeschoben, als in der Figur 11 gezeigt, treffen die Spitzen der vorderen Abschnitte 56 der Stifte 54 auf die Schrägflächen 36 auf und verlagern die ersten Verriegelungselemente 24 von den Wandungen des unteren Gehäuseteils 10 und den zweiten Verriegelungselementen weg nach innen, bis die Verriegelungsöffnungen 26 der ersten Verriegelungselemente 24 schließlich an den Verriegelungsvorsprüngen 48 am unteren Gehäuseteil 10 seitlich vorbei gelangen können, sodass das obere Gehäuseteil 12 nach oben von dem unteren Gehäuseteil 10 entfernt werden kann.

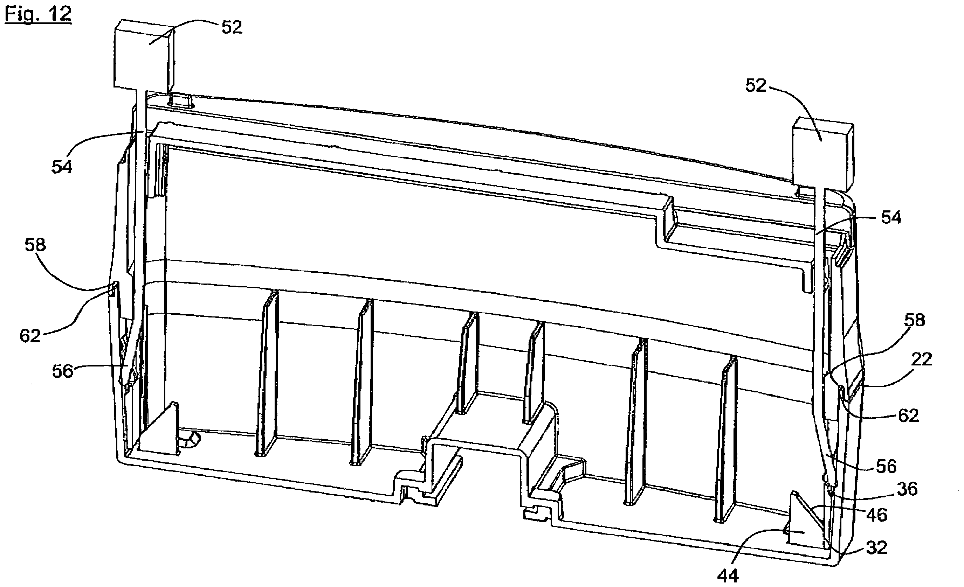

In der Fig. 12 ist die Anordnung der Fig. 11 bei anderer Schnittebene dargestellt. Man erkennt hier auch für die beiden hinteren Stifte 54 der Entriegelungswerkzeuge 50 die Anordnung der vorderen Abschnitte 56 der Stifte in einer Stellung kurz vor dem Auftreffen auf die Schrägflächen 36 der ersten Verriegelungselemcntc 24.

Ebenfalls gut in der Fig. 12 erkennbar ist, wie das untere Gehäuseteil 10 und das obere Gehäuseteil 12 entlang der Trennungsebene 22 zusammengesetzt sind. Hierzu ist am oberen Gehäuseteil 12 eine Nut 58 ausgebildet, in die ein am unteren Gehäuseteil 10 umlaufender Steg 62 eingreift. Dadurch wird jede seitliche Relativbewegung zwischen dem unteren Gehäuseteil 10 und dem oberen Gehäuseteil 12 zuverlässig verhindert.

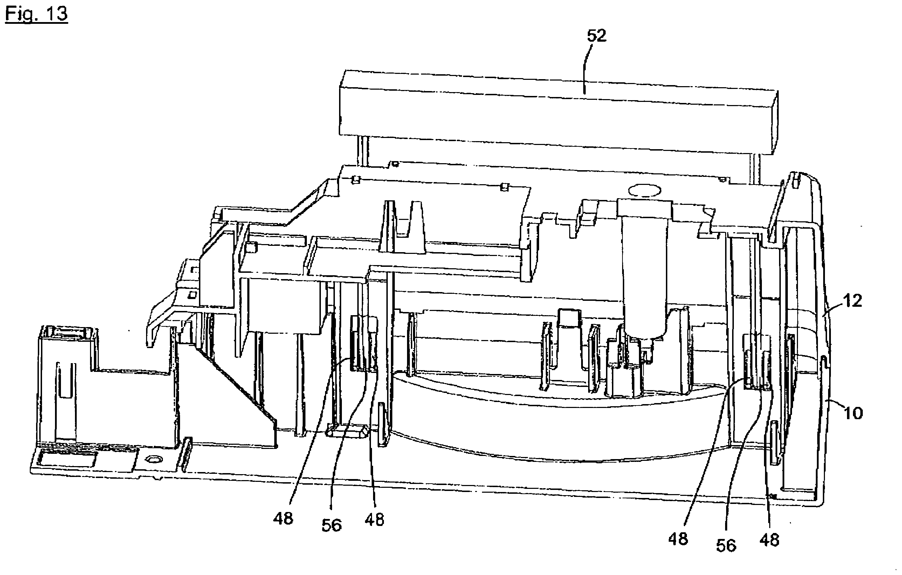

Fig. 13 zeigt einen weiteren Blick in das Innere des Gehäuses, ähnlich wie die Fig. 8, jedoch mit einem in die Entriegelungsöffnungen 38 eingeführten Entriegelungswerkzeug 50. In dieser Darstellung erkennt man besonders gut, dass die vorderen Abschnitte 56 der Stifte 54 gerade zwischen zwei benachbart angeordnete Verriegelungsvorsprünge 48 bzw. in den dort ausgebildeten Freiraum 60 vorgeschoben werden.

### Liste der verwendeten Bezugszeichen:

- 10: unteres Gehäuseteil
- 12: oberes Gehäuseteil
- 14: Abdeckung
- 16: Klemmendeckel
- 18: Plombierschraube
- 20: Stiftplombe
- 22: Trennungsebene
- 24: erstes Verriegelungselement
- 26: Verriegelungsöffnung
- 28: Verriegelungsabschnitt
- 30: Verriegelungsöffnung
- 32: freies Ende
- 34: Anschlagfläche
- 36: Schrägfläche
- 38: Entriegelungsöffnung
- 40: Abdeckungsverriegelungsvorsprung
- 42: Grundplatte
- 44: Steg
- 46: Verriegelungsfläche
- 48: Verriegelungsvorsprung
- 50: Entriegelungswerkzeug
- 52: Griffabschnitt
- 54: Stift
- 56: vorderer Abschnitt
- 58: Nut
- 60: Freiraum
- 62: Steg
- 64: Führungsfläche

## Patentansprüche

1. Elektrizitätszähler mit einem unteren Gehäuseteil (10), an dem Anschlussklemmen oder -kontakte zum Anschließen an ein Versorgungsnetz befestigt sind, und einem oberen Gehäuseteil (12), das eine Frontseite des Elektrizitätszählers oder Teile davon bildet, wobei das untere Gehäuseteil (10) erste Verriegelungselemente (24) und das obere Gehäuseteil (12) zweite Verriegelungselemente aufweist oder umgekehrt, wobei die ersten Verriegelungselemente (24) und die zweiten Verriegelungselemente dazu ausgebildet sind, beim Zusammensetzen der beiden Gehäuseteile (10, 12) ineinander einzurasten, so dass sie sich anschließend im Inneren eines von den beiden Gehäuseteilen (10, 12) gebildeten, geschlossenen Gehäuses befinden, wobei das Gehäuse Entriegelungsöffnungen (38) aufweist, durch die die ersten und/oder zweiten Verriegelungselemente (24) bei geschlossenem Gehäuse von außen zugänglich sind, so dass sie in eine nicht ineinander eingerastete Stellung verlagert werden können, **dadurch gekennzeichnet, dass** die Entriegelungsöffnungen (38) in dem oberen Gehäuseteil (12) ausgebildet sind und der Elektrizitätszähler eine ein Sichtfenster aufweisende Abdeckung (14) umfasst, die in einer Geschlossenstellung die Entriegelungsöffnungen (38) abdeckt und vor unberechtigtem Zugriff schützt, wobei hinter dem Sichtfenster ein Schild, eine elektronische Anzeige und/oder eine optische Schnittstelle des Elektrizitätszählers angeordnet ist.

2. Elektrizitätszähler nach Anspruch 1, **dadurch gekennzeichnet, dass** die Abdeckung (14) dazu ausgebildet ist, mittels einer Plombe in der Geschlossenstellung gesichert zu werden.

3. Elektrizitätszähler nach Anspruch 1 oder 2, **dadurch gekennzeichnet, dass** die Abdeckung (14) so ausgebildet ist, dass sie nicht zerstörungsfrei aus der Geschlossenstellung entfernt werden kann.

4. Elektrizitätszähler nach einem der Ansprüche 1 bis 3, **dadurch gekennzeichnet, dass** die Abdeckung (14) Verriegelungsabschnitte (28) aufweist, die in der Geschlossenstellung in die Entriegelungsöffnungen (38) eingreifen und diese verschließen.

5. Elektrizitätszähler nach Anspruch 4, **dadurch gekennzeichnet, dass** die Verriegelungsabschnitte (28) der Abdeckung (14) Verriegelungsausnehmungen oder Verriegelungsöffnungen (30) aufweisen und das obere Gehäuseteil (12) Abdeckungsverriegelungsvorsprünge (40), die in der Geschlossenstellung in die Verriegelungsausnehmungen oder Verriegelungsöffnungen (30) eingreifen.

6. Elektrizitätszähler nach einem der Ansprüche 1 bis 5, **dadurch gekennzeichnet, dass** die Entriegelungsöffnungen (38) bei geschlossenem Gehäuse relativ zu den ersten und zweiten Verriegelungselementen (24) so angeordnet sind, dass ein stiftförmiges Entriegelungswerkzeug (50) durch eine Entriegelungsöffnung (38) hindurch zwischen ein erstes Verriegelungselement (24) und ein zweites Verriegelungselement geschoben werden kann.

7. Elektrizitätszähler nach Anspruch 6, **dadurch gekennzeichnet, dass** am oberen Gehäuseteil (12) und/oder am unteren Gehäuseteil (10) Führungsflächen (64) ausgebildet sind, entlang denen das Entriegelungswerkzeug (50) zwischen ein erstes und ein zweites Verriegelungselement (24) geschoben werden kann.

8. Elektrizitätszähler nach Anspruch 7, **dadurch gekennzeichnet, dass** die Abdeckungsverriegelungsvorsprünge (40) rippenförmige Rastnasen und die Führungsflächen (64) seitliche Flächen dieser Rastnasen sind.

9. Elektrizitätszähler nach einem der Ansprüche 6 bis 8, **dadurch gekennzeichnet, dass** die ersten Verriegelungselemente (24) jeweils eine Verriegelungsöffnung (26) und die zweiten Verriegelungselemente jeweils zwei benachbart angeordnete Verriegelungsvorsprünge (48) aufweisen, die dazu ausgebildet sind, beide in dieselbe Verriegelungsöffnung (26) einzugreifen, wobei zwischen den beiden Verriegelungsvorsprüngen (48) ein Freiraum (60) ausgebildet ist, durch den das Entriegelungswerkzeug (50) vorgeschoben werden kann.

10. Elektrizitätszähler nach einem der Ansprüche 6 bis 9, **dadurch gekennzeichnet, dass** die ersten Verriegelungselemente (24) jeweils eine Schrägfläche (36) aufweisen, die so angeordnet ist, dass das durch eine Entriegelungsöffnung (38) eingeschobene, gegen die Schrägfläche (36) gepresste Entriegelungswerkzeug (50) das betreffende erste Verriegelungselement (24) von dem zugehörigen zweiten Verriegelungselement entfernt.

11. Elektrizitätszähler nach Anspruch 10, **dadurch gekennzeichnet, dass** die Schrägflächen (36) jeweils an einer der Verriegelungsöffnungen (26) zwischen zwei Anschlagflächen (34) angeordnet sind, hinter denen bei geschlossenem Gehäuse jeweils einer der Verriegelungsvorsprünge (48) eingerastet ist.

12. Elektrizitätszähler nach einem der Ansprüche 1 bis 11, **dadurch gekennzeichnet, dass** am unteren Gehäuseteil (10) Verriegelungsflächen (46) ausgebildet sind, die bei geschlossenem Gehäuse jeweils eine Auslenkung eines freies Ende (32) eines der am oberen Gehäuseteil (12) angeordneten Verriegelungselemente (24) verhindern.

13. Elektrizitätszähler nach einem der Ansprüche 1 bis 12 mit einem Entriegelungswerkzeug (50), das zwei über einen Griffabschnitt (52) miteinander verbundene, parallel verlaufende Stifte (54) aufweist.

14. Elektrizitätszähler nach Anspruch 13, **dadurch gekennzeichnet, dass** die Stifte (54) jeweils einen geradlinigen Abschnitt aufweisen, der mit dem Griffabschnitt (52) verbunden ist, und einen vorderen Abschnitt (56), der gegenüber dem geradlinigen Abschnitt abgewinkelt ist.

## Claims

1. An electricity meter with a bottom housing part (10) to which connecting terminals or contacts are fastened for connecting to a power supply, and a top housing part (12) that forms a front side of the electricity meter or parts thereof, wherein the bottom housing part (10) has first locking elements (24), and the top housing part (12) has second locking elements or vice versa, wherein the first locking elements (24) and the second locking elements are designed to engage with each other when joining the two housing parts (10, 12) such that they are then located within the interior of an enclosed housing formed by the two housing parts (10, 12), wherein the housing has unlocking openings (38) through which the first and/or second locking elements (24) are accessible from the outside when the housing is closed such that they can be moved into an unengaged position with each other, **characterized in that** the unlocking openings (38) are formed in the top housing part (12), and the electricity meter comprises a cover (14) having an inspection window that, when in a closed position, covers the unlocking openings (38) and protects from unauthorized access, wherein a sign, an electronic display, and/or an optical interface with the electricity meter is arranged behind the inspection window.

2. The electricity meter according to claim 1, **characterized in that** the cover (14) is designed to be secured with a seal when in the closed position.

3. The electricity meter according to claim 1 or 2, **characterized in that** the cover (14) is designed so that it cannot be removed from the closed position without being destroyed.

4. The electricity meter according to one of claims 1 to 3, **characterized in that** the cover (14) has locking sections (28) that, when in the closed position, engage in the unlocking openings (38) and close them.

5. The electricity meter according to claim 4, **characterized in that** the locking sections (28) of the cover (14) have locking recesses or locking openings (30), and the top housing part (12) has cover locking projections (40) which, when in the closed position, engage in the locking recesses or locking openings (30).

6. The electricity meter according to one of claims 1 to 5, **characterized in that** when the housing is closed, the unlocking openings (38) are arranged relative to the first and second locking elements (24) such that a pin-shaped unlocking tool (50) can be shoved through an unlocking opening (38) between a first locking element (24) and second locking element.

7. The electricity meter according to claim 6, **characterized in that** guide surfaces (64) are formed on the top housing part (12) and/or on the bottom housing part (10), along which the unlocking tool (50) can be shoved between a first and a second locking element (24).

8. The electricity meter according to claim 7, **characterized in that** the cover locking projections (40) are rib-shaped detent lugs, and the guide surfaces (64) are lateral surfaces of these detent lugs.

9. The electricity meter according to one of claims 6 to 8, **characterized in that** the first locking elements (24) each have a locking opening (26), and the second locking elements each have two adjacently arranged locking projections (48) which are designed to both engage in the same locking opening (26), wherein a gap (60) is formed between the two locking projections (48) through which the unlocking tool (50) can be advanced.

10. The electricity meter according to one of claims 6 to 9, **characterized in that** the first locking elements (24) each have an oblique surface (36) that is arranged such that the unlocking tool (50) inserted through an unlocking opening (38) and pressed against the oblique surface (36) removes the relevant first locking element (24) from the associated second locking element.

11. The electricity meter according to claim 10, **characterized in that** the oblique surfaces (36) are each arranged at one of the locking openings (26) between two contact surfaces (34), behind which one of the locking projections (48) is engaged when the housing is closed.

12. The electricity meter according to one of claims 1 to 11, **characterized in that** locking surfaces (46) are formed on the bottom housing part (10), and each prevent a disengagement of a free end (32) of one of the locking elements (24) arranged on the top housing part (12) when the housing is closed.

13. The electricity meter according to one of claims 1 to 12 with an unlocking tool (50) that has two pins (54) that run parallel and are connected to each other by a grip section (52).

14. The electricity meter according to claim 13, **characterized in that** the pins (54) each have a linear section that is connected to the grip section (52) and a front section (56) that is angled relative to the linear section.

## Revendications

1. Compteur électrique avec un élément de boîtier inférieur (10), sur lequel des bornes ou des contacts de connexion sont fixés pour être raccordés à un réseau d'alimentation, et avec un élément de boîtier supérieur (12), qui forme une façade du compteur électrique ou des parties de celui-ci, dans lequel l'élément de boîtier inférieur (10) présente de premiers organes de verrouillage (24) et l'élément de boîtier supérieur (12) de seconds organes de verrouillage ou inversement, dans lequel les premiers organes de verrouillage (24) et les seconds organes de verrouillage sont conçus de manière à s'enclencher les uns dans les autres lors de l'assemblage des deux éléments de boîtier (10, 12), de sorte qu'ils se trouvent ensuite à l'intérieur d'un boîtier fermé, formé par les deux éléments de boîtier (10, 12), dans lequel le boîtier présente des ouvertures de déverrouillage (38), à travers lesquelles les premiers et/ou les seconds organes de verrouillage (24) sont accessibles de l'extérieur lorsque le boîtier est fermé, si bien qu'ils peuvent être déplacés dans une position non mutuellement encliquetée, **caractérisé en ce que** les ouvertures de déverrouillage (38) sont constituées dans l'élément de boîtier supérieur (12) et que le compteur électrique comprend un couvercle (14) présentant un regard, qui recouvre les ouvertures de déverrouillage (38) dans une position fermée et protège contre tout accès non autorisé, dans lequel un blindage, un afficheur électronique et/ou une interface optique du compteur électrique sont disposés derrière le regard.

2. Compteur électrique selon la revendication 1, **caractérisé en ce que** le couvercle (14) est conçu de manière à être sécurisé par un plomb dans la position fermée.

3. Compteur électrique selon la revendication 1 ou 2, **caractérisé en ce que** le couvercle (14) est conçu de manière à ce qu'il ne puisse être enlevé de façon non destructive de la position fermée.

4. Compteur électrique selon l'une des revendications 1 à 3, **caractérisé en ce que** le couvercle (14) présente des segments de verrouillage (28), qui s'engagent dans les ouvertures de déverrouillage (38) en position fermée et obturent celles-ci.

5. Compteur électrique selon la revendication 4, **caractérisé en ce que** les segments de verrouillage (28) du couvercle (14) présentent des évidements de verrouillage ou des ouvertures de verrouillage (30) et que l'élément de boîtier supérieur (12) possède des ressauts de verrouillage du couvercle (40), qui s'engagent dans les évidements de verrouillage ou les ouvertures de verrouillage (30) en position fermée.

6. Compteur électrique selon l'une des revendications 1 à 5, **caractérisé en ce que** les ouvertures de déverrouillage (38) sont disposées par rapport aux premiers et aux seconds organes de verrouillage (24) lorsque le boîtier est fermé, de manière à ce qu'un outil de déverrouillage (50) en forme de goupille peut être enfilé à travers une ouverture de déverrouillage (38) entre un premier organe de verrouillage (24) et un second organe de verrouillage.

7. Compteur électrique selon la revendication 6, **caractérisé en ce que** des surfaces de guidage (64) sont constituées sur l'élément de boîtier supérieur (12) et/ou sur l'élément de boîtier inférieur (10), le long desquelles l'outil de déverrouillage (50) peut être enfilé entre un premier et un second organe de verrouillage (24).

8. Compteur électrique selon la revendication 7, **caractérisé en ce que** les ressauts de verrouillage du couvercle (40) sont des ergots d'encliquetage en forme de nervures et les surfaces de guidage (64) sont des faces latérales de ces ergots d'encliquetage.

9. Compteur électrique selon l'une des revendications 6 à 8, **caractérisé en ce que** les premiers organes de verrouillage (24) présentent respectivement une ouverture de verrouillage (26) et les seconds organes de verrouillage respectivement deux ressauts de verrouillage (48) disposés de façon adjacente, qui sont conçus de manière à ce que les deux s'engagent dans la même ouverture de verrouillage (26), dans lequel un espace libre (60) est constitué entre les deux ressauts de verrouillage (48), à travers lequel l'outil de déverrouillage (50) peut être avancé.

10. Compteur électrique selon l'une des revendications 6 à 9, **caractérisé en ce que** les premiers organes de verrouillage (24) présentent respectivement une surface oblique (36), qui est disposée de manière à ce que l'outil de déverrouillage (50) inséré à travers une ouverture de déverrouillage (38) et pressé contre la surface oblique (36) enlève le premier organe de verrouillage concerné (24) du second organe de verrouillage associé.

11. Compteur électrique selon la revendication 10, **caractérisé en ce que** les surfaces obliques (36) sont disposées respectivement à l'une des ouvertures de verrouillage (26) entre deux surfaces de butée (34), derrière lesquelles l'un des ressauts de verrouillage (48) est respectivement enclenché lorsque le boîtier est fermé.

12. Compteur électrique selon l'une des revendications 1 à 11, **caractérisé en ce que** des surfaces de verrouillage (46) sont constituées sur l'élément de boîtier inférieur (10), qui empêchent respectivement une déviation d'une extrémité libre (32) de l'un des organes de verrouillage (24) disposés sur l'élément de boîtier supérieur (12) lorsque le boîtier est fermé.

13. Compteur électrique selon l'une des revendications 1 à 12 avec un outil de déverrouillage (50), qui présente deux tiges (54) évoluant en parallèle et reliée l'une à l'autre par une poignée (52).

14. Compteur électrique selon la revendication 13, **caractérisé en ce que** les tiges (54) présentent respectivement un segment rectiligne, qui est relié à la poignée (52), et un segment antérieur (56), qui est coudé par rapport au segment rectiligne.
